# EUROPEAN PATENT APPLICATION

(11) **EP 4 271 161 A1**
(43) Date of publication of application: **01.11.2023**
(21) Application number: 23162004.8
(22) Date of filing: 15.03.2023
(51) Int. Cl.: H10K 59/10

(54) **DISPLAY DEVICE AND ELECTRONIC DEVICE INCLUDING THE SAME**

(30) Priority: 25.04.2022 KR 20220050527; 28.11.2022 KR 20220161709
(71) Applicant: Samsung Display Co., Ltd., Yongin-si, Gyeonggi-do 17113 (KR)
(72) Inventor: LEE, Donghyeok, 17113 Yongin-si (KR); TAE, Seunggyu, 17113 Yongin-si (KR); KO, Moosoon, 17113 Yongin-si (KR); MA, Jin Seock, 17113 Yongin-si (KR); YANG, Yongho, 17113 Yongin-si (KR); YOO, Ki-Bok, 17113 Yongin-si (KR); LEE, Jin-Suk, 17113 Yongin-si (KR)
(74) Representative: Walaski, Jan Filip

(57) **Abstract**

A display device includes a base layer (BL) including a plurality of pixel regions (PXA), which include a first pixel region (PX-B), a second pixel region (PX-R), and a non-pixel region (NPXA), a pixel defining film (PDL) disposed on the non-pixel region of the base layer and including a pixel opening (OPP) disposed corresponding to each of the plurality of pixel regions, and a light-emitting element layer. A valley pattern (VP) surrounding a portion of each of the plurality of pixel regions is defined in the pixel defining film and includes a first valley pattern (VP1) and a second valley pattern (VP2). An opening portion is defined at which the valley pattern does not surround the pixel regions and includes a first opening portion (OPP1) and a second opening portion (OPP2). The first opening portion and the second opening portion do not face each other.

## Description

### CROSS-REFERENCE TO RELATED APPLICATIONS

This application claims priority to Korean Patent Application Nos. 10-2022-0050527 and 10-2022-0161709, filed on April 25, 2022 and November 28, 2022, in the Korean Intellectual Property Office (KIPO).

### BACKGROUND

### 1. Technical Field

The disclosure herein relates to a display device, which has improved luminance and prevents color mixing, and an electronic device including the same.

### 2. Description of the Related Art

An electronic device, such as a smart phone, a tablet, a digital camera, a notebook computer, a navigation system, and a television, which provides an image to a user, includes a display device configured to display an image.

In the display device, pixels may be divided into red, green, and blue pixels for color display, and a light-emitting layer corresponding to each color may be formed for each pixel. In general, a deposition method using a shadow mask is used for the light-emitting layer, but defects such as sagging of the mask may occur. Therefore, a process has been developed in which the light-emitting layer and additional organic layer are formed in common in all pixels by using an open mask.

However, when the organic layer is commonly formed, a lateral current leakage may occur due to the organic layer provided in common between adjacent pixels, and because of this, color mixing and luminance defects may occur between adjacent pixels.

### SUMMARY

The disclosure provides a display device capable of preventing an excessive increase in a driving voltage while preventing color mixing and luminance decrease between adjacent pixels, and an electronic device including the display device.

An embodiment of the disclosure provides a display device that may include a base layer including a plurality of pixel regions, which include a first pixel region and a second pixel region adjacent to the first pixel region, and a non-pixel region disposed adjacent to the plurality of pixel regions, a pixel defining film disposed on the non-pixel region of the base layer and including a pixel opening disposed corresponding to each of the plurality of pixel regions, and a light-emitting element layer at least partially disposed in the pixel opening. A valley pattern surrounding a portion of each of the plurality of pixel regions may be defined in the pixel defining film. The valley pattern may include a first valley pattern surrounding a portion of the first pixel region and a second valley pattern surrounding a portion of the second pixel region. An opening portion may be defined at which the valley pattern does not surround the plurality of pixel region. The opening portion may include a first opening portion corresponding to the first valley pattern and a second opening portion corresponding to the second valley pattern. The first opening portion and the second opening portion may not face each other.

In an embodiment, the valley pattern may have a shape recessed from an upper surface of the pixel defining film in a thickness direction of the pixel defining film.

In an embodiment, a depth of the valley pattern may be in a range of about 100 nm to about 500 nm.

In an embodiment, the valley pattern may include a lower surface parallel to the upper surface of the pixel defining film and a side surface connecting the lower surface of the valley pattern and the upper surface of the pixel defining film to each other and inclined from the lower surface of the valley pattern. An angle of the side surface may be in a range of about 70 degrees to about 90 degrees.

In an embodiment, the light-emitting element layer may include a first electrode disposed on the base layer, an organic layer disposed on the first electrode and the pixel defining film and including a light-emitting layer, and a second electrode disposed on the organic layer. A portion of the organic layer and a portion of the second electrode may be disposed in the valley pattern.

In an embodiment, the organic layer may include a first portion disposed on the upper surface of the pixel defining film and a second portion disposed on the side surface. A thickness of the second portion may be less than a thickness of the first portion in the thickness direction.

In an embodiment, the thickness of the second portion may be in a range of about 10% to about 20% of the thickness of the first portion.

In an embodiment, the second electrode may include a first electrode portion disposed on the upper surface of the pixel defining film, and a second electrode portion disposed on the side surface. A thickness of the second electrode portion may be less than a thickness of the first electrode portion in the thickness direction.

In an embodiment of the disclosure, a display device may further include a dummy portion disposed on the pixel defining film and partially overlapping the valley pattern in a plan view. The organic layer may include a third portion disposed on the dummy portion and a fourth portion disposed on the lower surface of the valley pattern. The third portion and the fourth portion may not be connected to each other.

In an embodiment, the dummy portion may include a protruding portion protruding from the side surface of the valley pattern. A length of the protruding portion may be in a range of about 0.05 micrometers to about 0.1 micrometers in a cross-sectional view.

In an embodiment, the organic layer may include a hole control layer disposed on the first electrode and the pixel defining film, the light-emitting layer disposed on the hole control layer, and an electron control layer disposed between the light-emitting layer and the second electrode.

In an embodiment, the organic layer may include a first light-emitting stack disposed on the first electrode and the pixel defining film and including a first light-emitting layer, a first charge generation layer disposed on the first light-emitting stack, and a second light-emitting stack disposed between the first charge generation layer and the second electrode and including a second light-emitting layer.

In an embodiment, at least a portion of the first pixel region and at least a portion of the second pixel region may be disposed adjacent to each other in a first direction. The first pixel region may include a first lateral side extending in a second direction intersecting the first direction and a second lateral side extending from the first lateral side in the first direction, and the second pixel region may include a third lateral side extending in the second direction and facing the first lateral side and a fourth lateral side extending from the third lateral side in the first direction. The first opening portion may be defined adjacent to the first lateral side, and the second opening portion may be defined adjacent to the fourth lateral side.

In an embodiment, at least a portion of the first pixel region and at least a portion of the second pixel region may be disposed adjacent to each other in a first direction. The first pixel region may include a first lateral side extending in a fourth direction that is a direction between the first direction and a second direction intersecting the first direction and a second lateral side extending from the first lateral side in a fifth direction intersecting the fourth direction, and the second pixel region may include a third lateral side extending in the fourth direction and a fourth lateral side extending from the third lateral side in the fifth direction. The first opening portion may be defined adjacent to two vertices at which the first lateral side and the second lateral side meet each other and which are spaced apart from each other in the first direction, and the second opening portion may be defined adjacent to two vertices at which the third lateral side and the fourth lateral side meet each other and which are spaced apart from each other in the second direction.

In an embodiment, the plurality of pixel regions may further include a third pixel region adjacent to the second pixel region. The valley pattern may further include a third valley pattern surrounding a portion of the third pixel region. The display device may further include a third opening portion disposed at which the third valley pattern does not surround the third pixel region. The third opening portion may not face the second opening portion.

In an embodiment, the first pixel region may emit a first light, the second pixel region may emit a second light having a wavelength different from that of the first light, and the third pixel region may emit a third light having a wavelength different from those of the first light and the second light.

In an embodiment, a ratio of the first opening portion and the first valley pattern may be in a range of about 10% to about 50%, and a ratio of the second opening portion and the second valley pattern may be in a range of about 10% to about 50%.

In an embodiment of the disclosure, a display device may include a base layer including a plurality of pixel regions, which include a first pixel region emitting first light and a second pixel region adjacent to the first pixel region and emitting second light having a wavelength different from that of the first light, and a non-pixel region disposed adjacent to the plurality of pixel regions, and a pixel defining film disposed on the non-pixel region of the base layer and including a pixel opening disposed corresponding to each of the plurality of pixel regions. A valley pattern surrounding a portion of each of the plurality of pixel regions may be defined in the pixel defining film. The valley pattern may include a first valley pattern surrounding a portion of the first pixel region and a second valley pattern surrounding a portion of the second pixel region. A first opening portion may be defined at which the first valley pattern does not surround the first pixel region, and a second opening portion may be defined at which the second valley pattern does not surround the second pixel region. Each of the first pixel region and the second pixel region may include sides extending in a first direction and a second direction intersecting the first direction. The first opening portion may be defined adjacent to the side extending in the second direction, and the second opening portion may be defined adjacent to the side extending in the first direction.

In an embodiment, at least a portion of the first pixel region and at least a portion of the second pixel region may be disposed adjacent to each other in the first direction. The first pixel region may include a first lateral side extending in the second direction and a second lateral side extending from the first lateral side in the first direction. The second pixel region may include a third lateral side extending in the second direction and facing the first lateral side and a fourth lateral side extending from the third lateral side in the first direction. The first opening portion may be defined adjacent to the first lateral side, and the second opening portion may be defined adjacent to the fourth lateral side.

In an embodiment of the disclosure, an electronic device may include a display module including a plurality of pixel regions, which include a first pixel region emitting first light and a second pixel region adjacent to the first pixel region and emitting second light having a wavelength different from that of the first light, and a non-pixel region disposed adjacent to the plurality of pixel regions, a window disposed on the display module, and an outer case disposed under the display module. The display module may include a base layer, a pixel defining film disposed on the base layer in the non-pixel region and including a pixel opening disposed corresponding to each of the plurality of pixel regions, and a light-emitting element layer at least partially disposed in the pixel opening. A valley pattern surrounding a portion of each of the plurality of pixel regions may be defined in the pixel defining film. The valley pattern may include a first valley pattern surrounding a portion of the first pixel region and a second valley pattern surrounding a portion of the second pixel region. A first opening may be defined at which the first valley pattern does not surround the first pixel region, and a second opening may be defined at which the second valley pattern does not surround the second pixel region. The first opening portion and the second opening portion may not face each other.

### BRIEF DESCRIPTION OF THE DRAWINGS

The accompanying drawings are included to provide a further understanding of the disclosure, and are incorporated in and constitute a part of this specification. The drawings illustrate embodiments of the disclosure and, together with the description, serve to explain principles of the disclosure. In the drawings:
FIG. 1 is a perspective view of an electronic device according to an embodiment of the disclosure;
FIG. 2 is an exploded perspective view of the electronic device according to an embodiment of the disclosure;
Each of FIGS. 3A to 3C is a perspective view of an electronic device according to an embodiment of the disclosure;
FIG. 4 is an exploded perspective view of the electronic device according to an embodiment of the disclosure;
FIG. 5 is a block diagram of electronic devices according to an embodiment of the disclosure;
FIG. 6A is a schematic cross-sectional view of a display module according to an embodiment of the disclosure;
FIG. 6B is a schematic cross-sectional view of a portion of a display panel included in the display module according to an embodiment of the disclosure;
FIG. 6C is a schematic cross-sectional view of a portion of a display panel according to another embodiment of the disclosure;
FIGS. 7A to 7C are enlarged plan views of a portion of the display panel according to an embodiment of the disclosure;
FIG. 8 is a schematic cross-sectional view of the display panel according to an embodiment of the disclosure;
FIGS. 9A and 9B are enlarged schematic cross-sectional views of portions of the display panel according to an embodiment of the disclosure; and
FIG. 10 is an enlarged schematic cross-sectional view of a portion of a display panel according to another embodiment of the disclosure.

### DETAILED DESCRIPTION OF THE EMBODIMENTS

Hereinafter, embodiments of the disclosure will be described with reference to the drawings.

When an element, such as a layer, is referred to as being "on", "connected to", or "coupled to" another element or layer, it may be directly on, connected to, or coupled to the other element or layer or intervening elements or layers may be present. When, however, an element or layer is referred to as being "directly on", "directly connected to", or "directly coupled to" another element or layer, there are no intervening elements or layers present. To this end, the term "connected" may refer to physical, electrical, and/or fluid connection, with or without intervening elements.

The same reference numerals or symbols refer to the same elements. In addition, in the drawings, thicknesses, ratios, and dimensions of components are exaggerated for effective description of technical content. In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

Although the terms "first", "second", etc. may be used herein to describe various types of elements, these elements should not be limited by these terms. These terms are used to distinguish one element from another element. Thus, a first element discussed below could be termed a second element without departing from the teachings of the disclosure. Singular expressions include plural expressions unless the context clearly indicates otherwise.

Spatially relative terms, such as "beneath", "below", "under", "lower", "above", "upper", "over", "higher", "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below", for example, can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a", "an", and "the" are intended to include the plural forms as well, unless the context clearly indicates otherwise. Moreover, the terms "comprises", "comprising", "includes", and/or "including" when used in this specification, specify the presence of stated features, integers, steps, operations, elements, components, and/or groups thereof, but do not preclude the presence or addition of one or more other features, integers, steps, operations, elements, components, and/or groups thereof.

The terms "about" or "approximately" as used herein is inclusive of the stated value and means within an acceptable range of deviation for the particular value as determined by one of ordinary skill in the art, considering the measurement in question and the error associated with measurement of the particular quantity (for example, the limitations of the measurement system). For example, "about" may mean within one or more standard deviations, or within ± 30%, 20%, 10%, 5% of the stated value.

In the application, "directly disposed" may mean that there is no layer, film, region, plate, etc. added between a portion such as a layer, film, region, or plate and another portion. For example, "direct disposed" may mean placing two layers or two members without using an additional member such as an adhesive member therebetween.

In the specification and the claims, the phrase "at least one of" is intended to include the meaning of "at least one selected from the group of" for the purpose of its meaning and interpretation. For example, "at least one of A and B" may be understood to mean "A, B, or A and B."

Unless otherwise defined, all terms (including technical and scientific terms) used in this specification have the same meaning as commonly understood by one of ordinary skill in the art to which this disclosure belongs. In addition, terms such as terms defined in commonly used dictionaries should be interpreted as having a meaning consistent with the meaning having in the context of the related technology, and should not be interpreted as too ideal or too formal unless explicitly defined here.

Hereinafter, a display device according to an embodiment of the disclosure will be described with reference to the accompanying drawings.

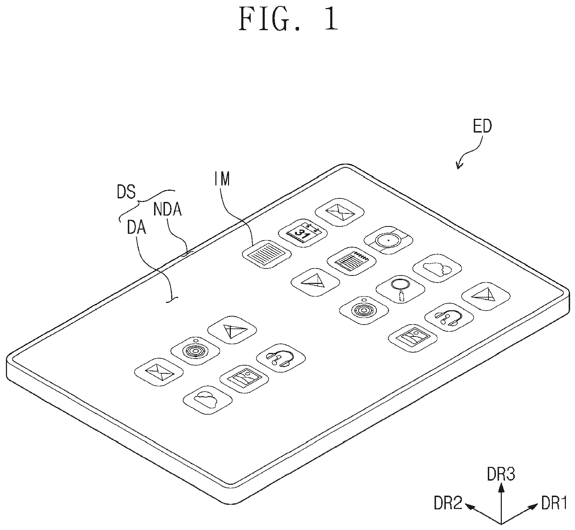

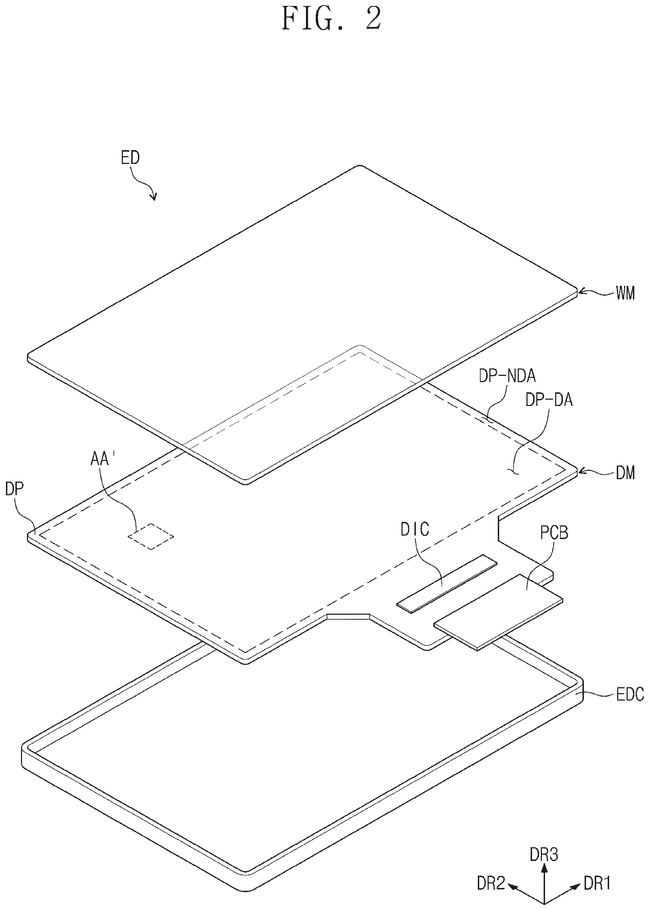

FIG. 1 is a perspective view of an electronic device according to an embodiment of the disclosure. FIG. 2 is an exploded perspective view of the electronic device according to an embodiment of the disclosure.

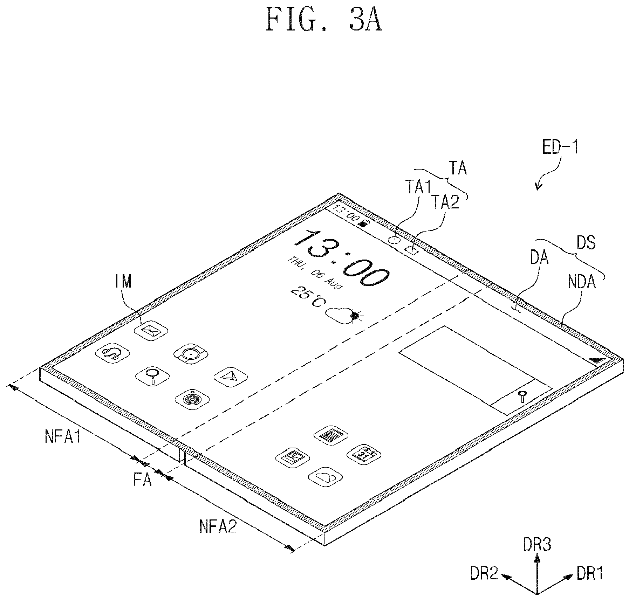

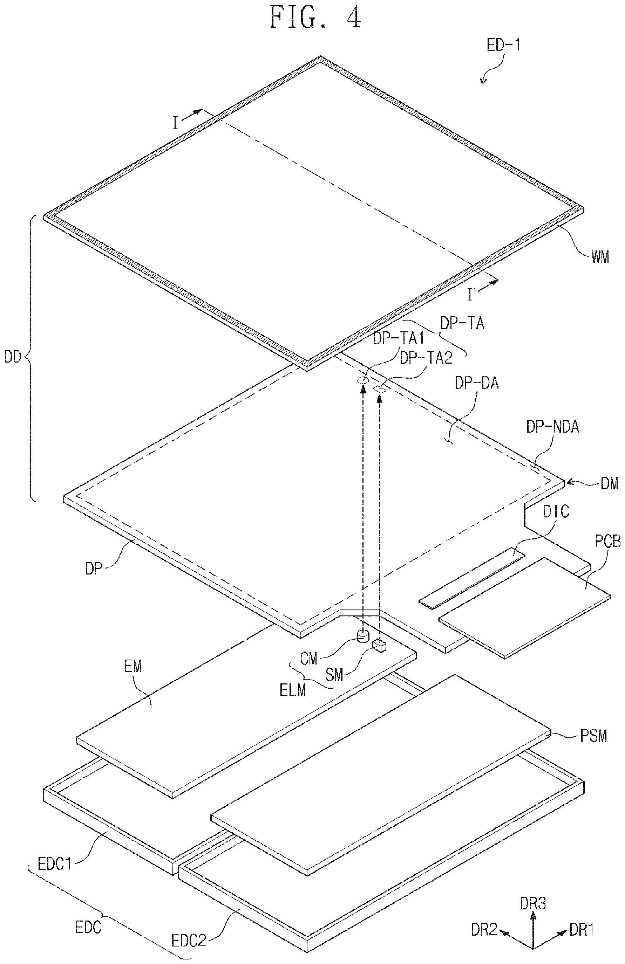

Referring to FIG. 1, the electronic device ED may be activated according to an electrical signal. The electronic device ED may display an image IM and sense an external input. The electronic device ED may include various embodiments. For example, the electronic device ED may include a tablet computer, a notebook computer, a computer, a smart phone, a television, and the like. In this embodiment, the electronic device ED is illustrated as a tablet. However, the device is not limited thereto, and the electronic device according to an embodiment of the disclosure may be a smartphone as illustrated in FIGS. 3A to 3C and FIG. 4. In another embodiment, the electronic device may be a large display device such as a notebook computer, a monitor, or a television.

The electronic device ED may display an image IM toward a third direction DR3 on a display surface DS parallel to each of a first direction DR1 and a second directions DR2 intersecting the first direction DR1. The display surface DS, on which an image IM is displayed, may correspond to not only the front surface of the electronic device ED, but also the front surface of a window WM (shown in FIG. 2). Hereinafter, the same reference numerals will be used for the display surface of the electronic device ED, the front surface thereof, and the front surface of the window WM. The image IM may include a still image as well as a dynamic image. FIG. 1 illustrates multiple icons as an example of the image IM.

In this embodiment, the front surface (or upper surface) and the rear surface (or lower surface) of each member are defined based on a direction in which the image IM is displayed. The front surface and the rear surface may be opposite to each other in the third direction DR3, and the normal direction of each of the front surface and the rear surface may be parallel to the third direction DR3. A separation distance between the front surface and the rear surface in the third direction DR3 may correspond to a thickness of the electronic device ED in the third direction DR3. The directions indicated by the first to third directions DR1, DR2, and DR3 are relative concepts and may be converted into other directions. Hereinafter, the first to third directions refer to the direction indicated by the reference numerals DR1, DR2, and DR3, respectively. In addition, the expression "on a plane" in this specification may mean a state of being viewed on a plane defined by the first direction DR1 and the second direction DR2.

The electronic device ED according to an embodiment of the disclosure may sense a user's input applied from the outside. The user's input may include various types of external inputs, such as a part of the user's body, light, heat, or pressure. The user's input may be provided in various forms, and the electronic device ED may sense the user's input applied to a side surface or rear surface of the electronic device ED according to the structure of the electronic device ED, but the disclosure is not limited to any one embodiment.

As illustrated in FIG. 2, the electronic device ED may include a window WM, a display module DM, and an outer case EDC. In this embodiment, the window WM and the outer case EDC may be coupled to each other to form the exterior of the electronic device ED. In this embodiment, the outer case EDC, the display module DM, and the window WM may be sequentially stacked along the third direction DR3.

The window WM includes an optically transparent material. The window WM may include an insulating panel. For example, the window WM may be composed of glass, plastic, or a combination thereof.

As described above, the front surface of the window WM may define the front surface of the electronic device ED.

The window WM may include a bezel region and a transmission region. The transmission region is an optically transparent region. For example, the transmission region may be a region having a visible light transmittance of greater than or equal to about 90%.

The bezel region may be a region having a relatively low light transmittance compared to the transmission region. The bezel region may define the shape of the transmission region. The bezel region may be disposed adjacent to and/or surround the transmission region. The bezel region may have a predetermined (or selectable) color. The bezel region may overlap a non-display region DP-NDA of a display panel DP, which will be described later. The bezel region may cover the non-display region DP-NDA of the display panel DP to block the non-display region DP-NDA from being viewed from the outside. However, the disclosure is not limited thereto, and in the window WM according to an embodiment of the disclosure, the bezel region may be omitted.

The display module DM may include at least a display panel DP. FIG. 2 illustrates only the display panel DP among the stacked structure of the display module DM, but substantially, the display module DM may also include multiple elements disposed above and below the display panel DP. A detailed description of the stacked structure of the display module DM will be given later.

The display panel DP may include a display region DP-DA and a non-display region DP-NDA corresponding to the display region DA (refer to FIG. 1) and the non-display region NDA (refer to FIG. 1) of the electronic device ED. In this specification, the expression "a region/portion corresponds to another region/portion" may mean that they overlap each other, but the expression may not be limited to having a same area. The display module DM may include a driving chip DIC disposed on the non-display region DP-NDA. The display module DM may also include a printed circuit board PCB coupled to the non-display region DP-NDA. The printed circuit board PCB may be electrically connected to pads disposed in the non-display region DP-NDA of the display panel DP by an anisotropic conductive adhesive layer.

The driving chip DIC may include driving elements configured to drive the pixels of the display panel DP, for example, a data driving circuit. Although FIG. 2A illustrates a structure in which the driving chip DIC is mounted on the display panel DP, the embodiment of the disclosure is not limited thereto. For example, the driving chip DIC may be mounted on the printed circuit board PCB.

The outer case EDC may accommodate the display module DM and be coupled to the window WM. The outer case EDC may protect elements, such as the display module DM accommodated therein.

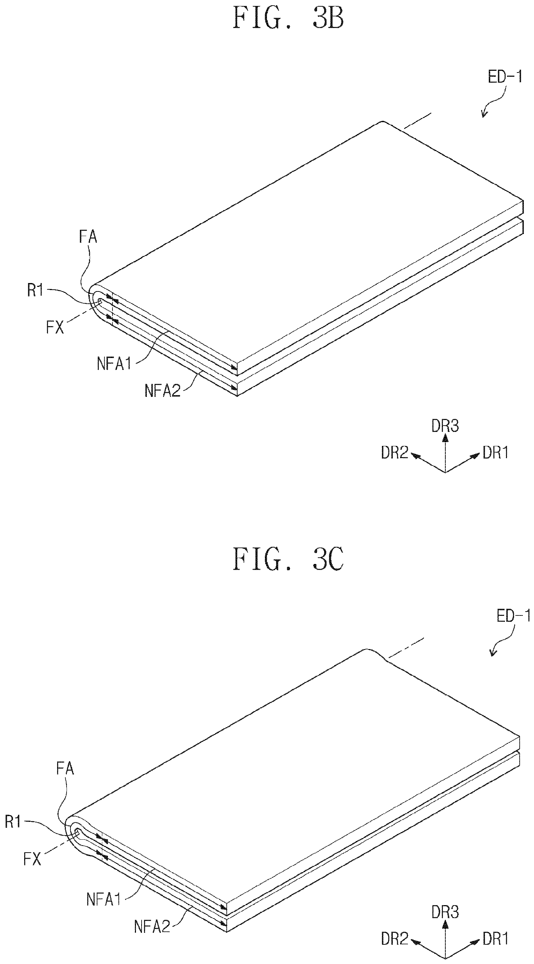

Each of FIGS. 3A to 3C is a perspective view of an electronic device according to another embodiment of the disclosure. FIG. 4 is an exploded perspective view of an electronic device according to another embodiment of the disclosure. FIG. 3A illustrates an unfolded state of an electronic device ED-1, and FIGS. 3B and 3C illustrate a folded state of the electronic device ED-1.

Referring to FIGS. 3A to 3C, the electronic device ED-1 according to an embodiment of the disclosure may include a display surface DS defined by the first direction DR1 and the second direction DR2 intersecting the first direction DR1. The electronic device ED-1 may provide a user with an image IM through the display surface DS.

The display surface DS may include a display region DA and a non-display region NDA adjacent to the display region DA. The display region DA may display an image IM, and the non-display region NDA may not display an image IM. The non-display region NDA may surround the display region DA. However, the embodiment of the disclosure is not limited thereto, and the shape of the display region DA and the shape of the non-display region NDA may be changed.

In the electronic device ED-1 according to an embodiment of the disclosure, the display surface DS may further include a signal transmission region TA. The signal transmission region TA may be a partial region of the display region DA or a partial region of the non-display region NDA. As illustrated in FIG. 3A, the signal transmission region TA may be a portion of the display region DA. The signal transmission region TA may have a higher light transmittance than the display region DA and the non-display region NDA. Natural light, visible light, and/or infrared light may enter to the signal transmission region TA. The electronic device ED-1 may further include a camera module configured to capture an external image by visible light passing through the signal transmission region TA, or a sensor module configured to determine the accessibility of an external object by infrared light.

Unlike what is illustrated in FIG. 3A, the signal transmission region TA according to an embodiment of the disclosure may extend from the non-display region NDA without being spaced apart from the non-display region NDA. Also, multiple transmission region TA may be provided.

The electronic device ED-1 may include a folding region FA and multiple non-folding regions NFA1 and NFA2. The non-folding regions NFA1 and NFA2 may include a first non-folding region NFA1 and a second non-folding region NFA2. In the second direction DR2, the folding region FA may be disposed between the first non-folding region NFA1 and the second non-folding region NFA2.

As illustrated in FIG. 3B, the folding region FA may be folded with respect to a folding axis FX parallel to the first direction DR1. The folding region FA may have a predetermined (or selectable) curvature and a predetermined (or selectable) curvature radius R1. In an embodiment, the first non-folding region NFA1 and the second non-folding region NFA2 may face each other in case that the electronic device ED-1 is folded, and the electronic device ED-1 may be inner-folded so that the display surface DS is not exposed to the outside.

In another embodiment of the disclosure, the electronic device ED-1 may be outer-folded so that the display surface DS is exposed to the outside. In an embodiment of the disclosure, the electronic device ED-1 may perform both an inner-folding operation and an outer-folding operation from an unfolding operation, but the embodiment of the disclosure is not limited thereto. In an embodiment of the disclosure, the electronic device ED-1 may be configured so as to select any one of an unfolding operation, an inner-folding operation, and an outer-folding operation.

As illustrated in FIG. 3B, a distance between the first non-folding region NFA1 and the second non-folding region NFA2 may be substantially equal to the curvature radius R1, but as illustrated in FIG. 3C, the distance between the first non-folding region NFA1 and the second non-folding region NFA2 may be smaller than the curvature radius R1. FIGS. 3B and 3C are illustrated based on the display surface DS, and the outer cases EDC (refer to FIG. 4) that form the exterior of the electronic device ED-1 may contact each other at the end regions of the first non-folding region NFA1 and the second non-folding region NFA2.

FIGS. 3A to 3C illustrate that the electronic device ED-1 includes two non-folding regions NFA1 and NFA2 and one folding region FA arranged therebetween. Without being limited thereto, however, the electronic device ED-1 may include multiple folding regions so as to be folded at multiple regions.

As illustrated in FIG. 4, the electronic device ED-1 may include a display device DD, a control module EM, a power supply module PSM, an electronic module ELM, and an outer case EDC. Although not illustrated separately, the outer case EDC may further include a mechanical structure, such as a hinge structure, configured to control the folding operation of the display device DD.

The display device DD may generate an image and sense an external input. The display device DD may include a window WM and a display module DM. The window WM may provide the front surface of the electronic device ED-1. The contents described above with reference to FIG. 2 may be equally applied to the description of the display module DM and the window WM.

In the electronic device ED-1 according to an embodiment of the disclosure, the display panel DP may further include a signal transmission region DP-TA. The signal transmission region TA may be an opening or a region having a lower resolution than the display region DP-DA. As a result, the signal transmission region DP-TA may have a higher transmittance than the display region DP-DA and the non-display region DP-NDA. The signal transmission region DP-TA of the display panel DP may correspond to the signal transmission region TA (refer to FIG. 3A) of the electronic device ED-1 described above. The signal transmission region DP-TA may include a first signal transmission region DP-TA1 corresponding to the camera module CM and a second signal transmission region DP-TA2 corresponding to the sensor module SM.

The outer case EDC may accommodate a display module DM, a control module EM, a power supply module PSM, and an electronic module ELM. The outer case EDC is illustrated as including two cases EDC1 and EDC2 separated from each other, but the embodiment of the disclosure is not limited thereto. Although not illustrated, the electronic device ED-1 may further include a hinge structure configured to connect the two cases EDC1 and EDC2 to each other. The outer case EDC may be coupled to the window WM. The outer case EDC may protect the elements accommodated therein, such as the display module DM, the control module EM, the power supply module PSM, and the electronic module ELM.

The electronic module ELM may be an electronic component configured to output or receive an optical signal. The electronic module ELM may transmit or receive an optical signal through a partial region of the electronic device ED-1 corresponding to the signal transmission region TA (refer to FIG. 3A). In this embodiment, the electronic module ELM may include a camera module CM. The camera module CM may take a picture of an external image by receiving a natural light signal through a first signal transmission region DP-TA1. The electronic module ELM may include a sensor module SM such as a proximity sensor or an ultraviolet light-emitting sensor. The sensor module SM may recognize a part of a user's body (e.g., fingerprint, iris, or face) through a second signal transmission region DP-TA2 or measure the distance between an object and the electronic device ED-1.

The electronic module ELM may be disposed below the display device DD. The electronic module ELM may be disposed corresponding to the signal transmission region DP-TA of the electronic device ED-1. for example, the electronic module ELM may overlap the signal transmission region DP-TA of the display panel DP in the third direction DR3. The signal transmission region DP-TA of the display panel DP may have a higher light transmittance than other regions of the display panel DP.

The power supply module PSM may supply power required for the overall operation of the electronic device ED. The power supply module PSM may include a conventional battery device.

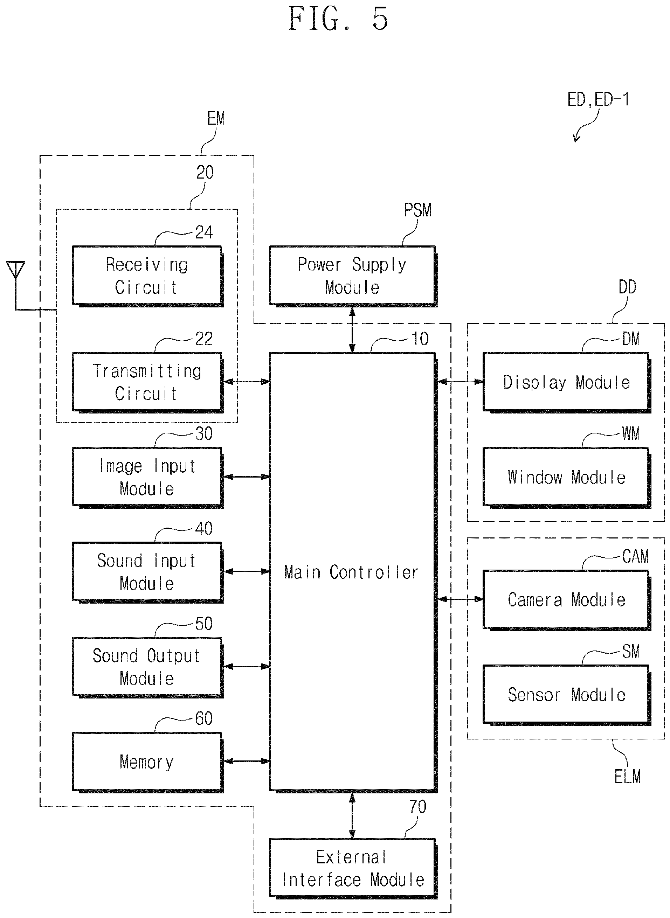

FIG. 5 is a block diagram of electronic devices according to an embodiment of the disclosure. In FIG. 5, the elements included in the above-described electronic devices ED and ED-1 are briefly illustrated by the block diagram, and the same reference numerals will be given to the aforementioned elements and the detailed descriptions thereof will be omitted.

The control module EM may include at least a main controller 10. The control module EM may include a main controller 10, a wireless communication module 20, an image input module 30, a sound input module 40, a sound output module 50, a memory 60, an external interface module 70, and the like. The modules may be mounted on the circuit board or electrically connected through a flexible circuit board. The control module EM may be electrically connected to the power supply module PSM.

The main controller 10 may control the overall operation of the electronic devices ED and ED-1. For example, the main controller 10 may activate or deactivate the display device DD in accordance with a user input. The main controller 10 may control the image input module 30, the sound input module 40, the sound output module 50, and the like in accordance with the user input. The main controller 10 may include at least one microprocessor.

The wireless communication module 20 may transmit or receive a wireless signal to and/or from another terminal by using a Bluetooth or Wi-Fi. The wireless communication module 20 may transmit or receive a voice signal by using a conventional communication line. The wireless communication module 20 may include a transmitting circuit 22 that modulates a signal to be transmitted and transmits the modulated signal, and a receiving circuit 24 that demodulates the received signal.

The image input module 30 may process image signals to convert them into image data that may be displayed on the display device DD. The sound input module 40 may receive external sound signals by a microphone in a recording mode, a voice recognition mode, or the like, and may convert them into electrical voice data. The sound output module 50 may convert sound data received from the wireless communication module 20 or sound data stored in the memory 60 and output them to the outside.

The external interface module 70 may serve as an interface connected to an external charger, a wired/wireless data port, a card socket (e.g., a memory card socket, a SIM/UIM card socket), and the like.

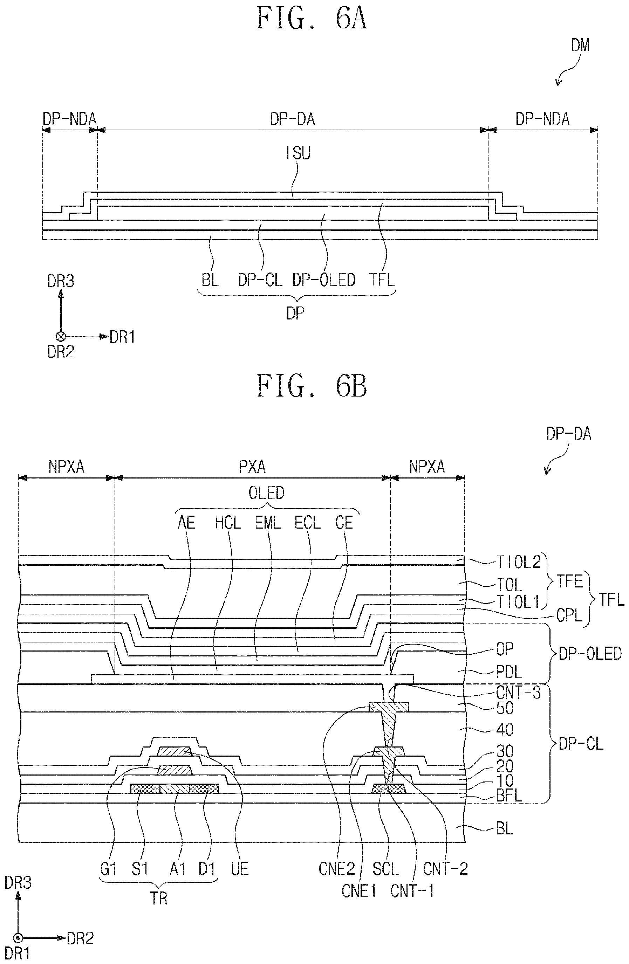

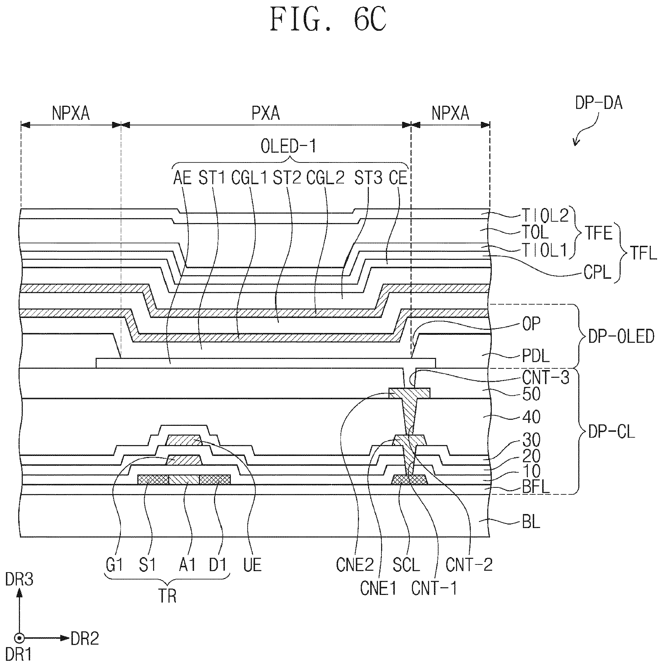

FIG. 6A is a schematic cross-sectional view of a display module according to an embodiment of the disclosure. FIG. 6B is a schematic cross-sectional view of a portion of a display panel included in the display module according to an embodiment of the disclosure. FIG. 6C is a schematic cross-sectional view of a portion of a display panel according to another embodiment of the disclosure. FIGS. 6B and 6C illustrate a light-emitting element and a transistor, which are included in a pixel included in the display panel according to an embodiment of the disclosure.

Referring to FIG. 6A, the display module DM may include a display panel DP and an input sensing unit ISU. The display panel DP may be configured to substantially generate an image IM (refer to FIGS. 1 and 3A). The image IM (refer to FIGS. 1 and 3A) generated by the display panel DP may be externally recognized by a user through the display region DP-DA (refer to FIGS. 1 and 3A).

The display panel DP may be a light-emitting display panel but is not particularly limited thereto. For example, the display panel DP may be an organic light-emitting display panel or an inorganic light-emitting display panel. The organic light-emitting display panel may be a display panel in which a light-emitting layer includes an organic light-emitting material. The inorganic light-emitting display panel may be a display panel in which a light-emitting layer includes quantum dots, quantum rods, or micro LEDs. Hereinafter, the display panel DP will be described as an organic light-emitting display panel.

The input sensing unit ISU may be disposed on the display panel DP. The input sensing unit ISU may sense an external input applied from the outside. The external input may include various types of inputs provided from the outside of the electronic device ED (refer to FIG. 1). The external input, which is applied from the outside, may be provided in various forms. For example, the external input may include a touch by a part of a body such as a user's hand, and also an external input (e.g., hovering) applied at a place close to or at a predetermined (or selectable) adjacent distance from the electronic device ED. The external input may also include various forms of inputs such as force, pressure, temperature, and light and is not limited to any one embodiment.

The input sensing unit ISU may be formed on the display panel DP through a continuous process. The input sensing unit ISU may be directly disposed on the display panel DP. In this specification, the expression "an element B is directly disposed on an element A" may mean that a third element is not disposed between the element A and the element B. For example, an adhesive layer may not be disposed between the input sensing unit ISU and the display panel DP.

The display panel DP may include a base layer BL, a circuit element layer DP-CL disposed on the base layer BL, a display element layer DP-OLED, and an upper insulating layer TFL.

The base layer BL may provide a base surface on which the circuit element layer DP-CL, the display element layer DP-OLED, and the upper insulating layer TFL are disposed. The base layer BL may be a rigid substrate or a flexible substrate capable of being bent, folded, rolled, etc. The base layer BL may be a glass substrate, a metal substrate, a polymer substrate, or the like. However, the embodiment of the disclosure is not limited thereto, and the base layer BL may include an inorganic layer, an organic layer, or a composite material layer.

The base layer BL may have a multi-layered structure. For example, the base layer BL may include a first synthetic resin layer, a multi- or single-layered inorganic layer, and a second synthetic resin layer disposed on the multi- or single-layered inorganic layer. Each of the first and second synthetic resin layers may include a polyimide-based resin, but the embodiment of the disclosure is not particularly limited thereto.

The circuit element layer DP-CL may be disposed on the base layer BL. The circuit element layer DP-CL may include multiple insulating layers, multiple conductive layers, and a semiconductor layer. The conductive layers of the circuit element layer DP-CL may constitute signal lines or a control circuit of a pixel.

The display element layer DP-OLED may be disposed on the circuit element layer DP-CL. The display element layer DP-OLED may include light-emitting elements. The display element layer DP-OLED may include, for example, organic light-emitting elements. However, the disclosure is not limited thereto, and the display element layer DP-OLED according to an embodiment of the disclosure may include inorganic light-emitting elements, organic-inorganic light-emitting elements, or a liquid crystal layer.

The upper insulating layer TFL may include a capping layer and a thin film encapsulation layer, which will be described later. The upper insulating layer TFL may include an organic layer and multiple inorganic layers configured to seal the organic layer.

The upper insulating layer TFL may be disposed on the display element layer DP-OLED to protect the display element layer DP-OLED from moisture, oxygen, and foreign substances such as dust particles. The upper insulating layer TFL may seal the display element layer DP-OLED so as to block moisture and oxygen from entering into the display element layer DP-OLED. The upper insulating layer TFL may include at least one inorganic layer. The upper insulating layer TFL may include an organic layer and multiple inorganic layers configured to seal the organic layer. The upper insulating layer TFL may include a structure stacked in the order of an inorganic layer, an organic layer, and an inorganic layer.

The input sensing unit ISU may be disposed on the upper insulating layer TFL. The input sensing unit ISU may be formed on the upper insulating layer TFL through a continuous process. The input sensing unit ISU may be directly disposed on the display panel DP. For example, a separate adhesive member may not be disposed between the input sensing unit ISU and the display panel DP. The input sensing unit ISU may be disposed to contact an inorganic layer disposed at the very top of the upper insulating layer TFL.

Although not illustrated separately, the display module DM according to an embodiment of the disclosure may further include a protective member disposed on the lower surface of the display panel DP and an anti-reflection member disposed on the upper surface of the input sensing unit ISU. The anti-reflection member may reduce the reflectance of external light. The anti-reflection member may be disposed directly on the input sensing unit ISU through a continuous process.

The anti-reflection member may include a light blocking pattern overlapping a reflective structure disposed below the anti-reflection member. The anti-reflection member may further include a color filter. The color filter may be disposed between light blocking patterns and include a first color filter, a second color filter, and a third color filter which correspond to a first color pixel, a second color pixel, and a third color pixel, respectively.

As illustrated in FIG. 6A, the display panel DP may be divided into a display region DP-DA and a non-display region DP-NDA on a plane. The display region DP-DA of the display panel DP may be a region in which an image is displayed, and the non-display region DP-NDA may be a region in which a driving circuit or a driving line is disposed. The light-emitting elements of each of the pixels may be disposed in the display region DP-DA. The display region DP-DA may overlap at least a portion of the transmission region (DP-TA of FIG. 4) of the display module DM, and the non-display region DP-NDA may be covered by the bezel region of the window WM. The display region DP-DA and the non-display region DP-NDA of the display panel DP may respectively correspond to the display region DA and the non-display region NDA of the electronic device ED illustrated FIG. 1.

Referring to FIGS. 6A and 6B, in the display panel DP according to an embodiment of the disclosure, a circuit element layer DP-CL, a display element layer DP-OLED, and an upper insulating layer TFL may be sequentially disposed above the base layer BL. The configuration of the circuit element layer DP-CL, the display element layer DP-OLED, and the upper insulating layer TFL will be described in detail with reference to FIG. 6B.

The circuit element layer DP-CL may include at least one insulating layer and one circuit element. The circuit element may include a signal line, a driving circuit of a pixel, and the like. The circuit element layer DP-CL may be formed through a process of forming an insulating layer, a semiconductor layer, and a conductive layer by coating, deposition, or the like, and a process of patterning the insulating layer, the semiconductor layer, and the conductive layer by a photolithography process.

A buffer layer BFL may include at least one inorganic layer. A semiconductor pattern may be disposed on the buffer layer BFL. The buffer layer BFL may improve the bonding force between the base layer BL and the semiconductor pattern.

The semiconductor pattern may include a polysilicon. However, the embodiment of the disclosure is not limited thereto, and the semiconductor pattern may include an amorphous silicon or a metal oxide. FIG. 3B illustrates only a portion of the semiconductor pattern, and the semiconductor pattern may be further disposed in another region of the pixel on a plane. The semiconductor pattern may be arranged in a specific pattern across the pixels.

The semiconductor pattern may have different electrical properties depending on whether it is doped or not. The semiconductor pattern may include a first region A1 having low doping concentration and conductivity and second regions S1 and D1 having relatively high doping concentration and conductivity. One of the second regions S1 may be disposed on a side of the first region A1, and another second region D1 may be disposed on another side of the first region A1. The second regions S1 and D1 may be doped with an N-type dopant or a P-type dopant. A P-type transistor may include a doped region doped with a P-type dopant. The first region A1 may be a non-doped region or may be doped with a lower concentration than that of the second regions S1 and D1.

The second regions S1 and D1 may substantially serve as electrodes or signal lines. One of the second regions S1 may correspond to a source of a transistor, and another second region D1 may be a drain. FIG. 6B illustrates a portion of a connection signal line SCL formed from the semiconductor pattern. Although not illustrated separately, the connection signal line SCL may be connected to the drain of the transistor TR.

A first insulating layer 10 may be disposed on the buffer layer BFL. The first insulating layer 10 may commonly overlap the pixels disposed in the display region DP-DA and may cover the semiconductor pattern. The first insulating layer 10 may be an inorganic layer and/or an organic layer and have a single-layered or multi-layered structure. The first insulating layer 10 may include at least one of aluminum oxide, titanium oxide, silicon oxide, silicon oxynitride, zirconium oxide, and hafnium oxide. Not only the first insulating layer 10, but also the insulating layer of the circuit element layer DP-CL to be described later may be an inorganic layer and/or an organic layer and have a single-layered or multi-layered structure.

A gate G1 may be disposed on the first insulating layer 10. The gate G1 may be a portion of a metal pattern. The gate G1 may overlap the first region A1 in the third direction DR3. In the process of doping the semiconductor pattern, the gate G1 may function as a mask.

A second insulating layer 20 may be disposed on the first insulating layer 10 and cover the gate G1. The second insulating layer 20 may overlap the pixels in common. An upper electrode UE may be disposed on the second insulating layer 20. The upper electrode UE may overlap the gate G1. The upper electrode UE may include a multi-layered metal layer. In an embodiment of the disclosure, the upper electrode UE may be omitted.

A third insulating layer 30 may be disposed on the second insulating layer 20 and cover the upper electrode UE. A first connection electrode CNE1 may be disposed on the third insulating layer 30. The first connection electrode CNE1 may be connected to the connection signal line SCL through a contact hole CNT-1 passing through the first to third insulating layers 10 to 30.

A fourth insulating layer 40 may be disposed on the third insulating layer 30, and a fifth insulating layer 50 may be disposed on the fourth insulating layer 40. The fourth insulating layer 40 may be an organic layer. A second connection electrode CNE2 may be disposed on the fourth insulating layer 40. The second connection electrode CNE2 may be connected to the first connection electrode CNE1 through a contact hole CNT-2 passing through the fourth insulating layer 40.

The fifth insulating layer 50 may be disposed on the fourth insulating layer 40 and cover the second connection electrode CNE2. The fifth insulating layer 50 may be an organic layer.

A light-emitting element OLED may be disposed on the fifth insulating layer 50. A first electrode AE may be disposed on the fifth insulating layer 50. The first electrode AE may be connected to the second connection electrode CNE2 through a contact hole CNT-3 passing through the fifth insulating layer 50. A pixel opening OP may be defined in a pixel defining film PDL, and the pixel defining film PDL may expose at least a portion of the first electrode AE. The pixel defining film PDL may be an organic layer.

As illustrated in FIG. 6B, the display region DP-DA may include a pixel region PXA and a non-pixel region NPXA adjacent to the pixel region PXA. The non-pixel region NPXA may surround the pixel region PXA. In this embodiment, the pixel region PXA may be defined to correspond to a partial region of the first electrode AE exposed by the pixel opening OP.

A hole control layer HCL may be commonly disposed in the pixel region PXA and the non-pixel region NPXA. The hole control layer HCL may include a hole transport layer and a hole injection layer. A light-emitting layer EML may be disposed on the hole control layer HCL.

An electron control layer ECL may be disposed on the light-emitting layer EML. The electron control layer ECL may include an electron transport layer and an electron injection layer. The hole control layer HCL, the light-emitting layer EML, and the electron control layer ECL may be commonly formed in the pixels by using an open mask. However, the embodiment of the disclosure is not limited thereto, and at least one of the hole control layer HCL, the light-emitting layer EML, and the electron control layer ECL may be formed by being patterned through a mask process. For example, the light-emitting layer EML may be disposed in a region corresponding to the pixel opening OP. For example, the light-emitting layer EML may be formed separately in each of the pixels.

A second electrode CE may be disposed on the electron control layer ECL. The second electrode CE may have an integral shape and be commonly disposed in the pixels.

The upper insulating layer TFL may be disposed on the display element layer DP-OLED and include multiple thin films. According to an embodiment of the disclosure, the upper insulating layer TFL may include a capping layer CPL and an encapsulation layer TFE disposed on the capping layer CPL. The capping layer CPL may be disposed on and in contact with the second electrode CE. The capping layer CPL may include an organic material.

The encapsulation layer TFE may include a first inorganic encapsulation layer TIOL1, an organic encapsulation layer TOL disposed on the first inorganic encapsulation layer TIOL1, and a second inorganic encapsulation layer TIOL2 disposed on the organic encapsulation layer TOL. The first inorganic encapsulation layer TIOL1 and the second inorganic encapsulation layer TIOL2 may protect the display element layer DP-OLED from moisture and/or oxygen, and the organic encapsulation layer TOL may protect the display element layer DP-OLED from foreign substances such as dust particles.

FIG. 6C illustrates a portion of a display panel including a light-emitting element OLED-1 different from the embodiment illustrated in FIG. 6B. Hereinafter, in describing the display panel according to another embodiment of the disclosure with reference to FIG. 6C, the same reference numerals will be given to the elements previously described with reference to FIG. 6B, and the detailed descriptions thereof will be omitted.

Referring to FIG. 6C, the light-emitting element OLED-1 included in the display panel according to an embodiment of the disclosure may include multiple light-emitting stacks ST1, ST2, and ST3 and charge generation layers CGL1 and CGL2 disposed between the light-emitting stacks ST1, ST2, and ST3. The light-emitting element OLED-1 according to an embodiment of the disclosure may include a first electrode AE, a first light-emitting stack ST1, a first charge generation layer CGL1, a second light-emitting stack ST2, a second charge generation layer CGL2, a third light-emitting stack ST3, and a second electrode CE, which are sequentially stacked. Although FIG. 6C illustrates that the light-emitting element OLED-1 includes three light-emitting stacks ST1, ST2, and ST3 and two charge generation layers CGL1 and CGL2 disposed therebetween, the disclosure is not limited thereto, and the light-emitting element OLED-1 may include two light-emitting stacks, or four or more light-emitting stacks.

Each of the light-emitting stacks ST1, ST2, and ST3 may include a light-emitting layer EML (refer to FIG. 6b), and a hole control layer HCL (refer to FIG. 6b) and an electron control layer ECL (refer to FIG. 6b) which are disposed with the light-emitting layer EML (refer to FIG. 6b) interposed therebetween. In an embodiment of the disclosure, the first light-emitting stack ST1 may include a first light-emitting layer, the second light-emitting stack ST2 may include a second light-emitting layer, and the third light-emitting stack ST3 may include a third light-emitting layer. For example, the light-emitting element OLED-1 may have a tandem structure including multiple light-emitting stacks including light-emitting layers.

In the embodiment illustrated in FIG. 6C, all of light emitted from each of the light-emitting stacks ST1, ST2, and ST3 may be light having a same wavelength. For example, light emitted from each of the light-emitting stacks ST1, ST2, and ST3 may be blue light. However, the embodiment of the disclosure is not limited thereto, and the wavelength ranges of light emitted from the light-emitting stacks ST1, ST2, and ST3 may be different from each other. For example, at least one of the light-emitting stacks ST1, ST2, and ST3 may emit blue light, and the other stacks may emit green light. The light-emitting element OLED-1 including the light-emitting stacks ST1, ST2, and ST3 configured to emit light having different wavelength ranges may emit white light.

The charge generation layers CGL1 and CGL2 may be disposed between the neighboring light-emitting stacks ST1, ST2, and ST3. Each of the charge generation layers CGL1 and CGL2 may include a p-type charge generation layer and/or an n-type charge generation layer. The n-type charge generation layer may be a charge generation layer configured to provide electrons to adjacent stacks. The n-type charge generation layer may be a layer in which a base material is doped with an n-dopant. The p-type charge generation layer may be a charge generation layer configured to provide holes to adjacent stacks. A buffer layer may be further disposed between the n-type charge generation layer and the p-type charge generation layer.

In case that a voltage is applied to the charge generation layers CGL1 and CGL2, a complex is formed through an oxidation-reduction reaction so that charges (electrons and holes) may be generated. The charge generation layers CGL1 and CGL2 may respectively provide generated charges to the adjacent light-emitting stacks ST1, ST2, and ST3. The charge generation layers CGL1 and CGL2 may double the efficiency of light generated in each of the adjacent light-emitting stacks ST1, ST2, and ST3 and play a role in controlling the balance of charges between the adjacent light-emitting stacks ST1, ST2, and ST3.

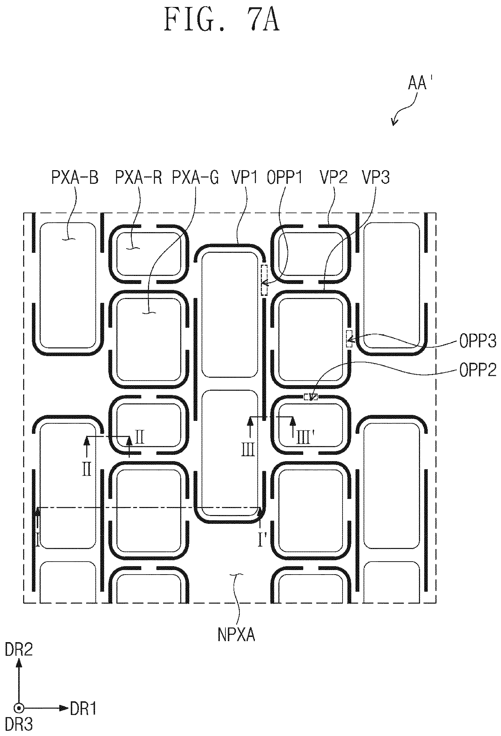

FIGS. 7A to 7C are enlarged plan views of a portion of the display panel according to an embodiment of the disclosure. FIGS. 7A to 7C illustrate enlarged views of an arrangement of pixels and a valley pattern defined to be adjacent thereto in region AA' illustrated in FIG. 2. Each of FIGS. 7A to 7C illustrates pixel regions having different arrangement and the shapes of valley patterns defined to be adjacent thereto.

Referring to FIGS. 2 and 7A together, in the display panel DP according to an embodiment of the disclosure, the display region DP-DA may include multiple pixel regions PXA-B, PXA-R, and PXA-G and a non-pixel region NPXA surrounding the pixel regions PXA-B, PXA-R, and PXA-G. The pixel regions PXA-B, PXA-R, and PXA-G may include a first pixel region PXA-B, a second pixel region PXA-R, and a third pixel region PXA-G. Each of the first pixel region PXA-B, the second pixel region PXA-R, and the third pixel region PXA-G may display light having a different wavelength. The first pixel region PXA-B may display a first light having a blue light wavelength, the second pixel region PXA-R may display a second light having a red light wavelength, and the third pixel region PXA-G may display a third light having a green light wavelength.

Each of the pixel regions PXA-B, PXA-R, and PXA-G may be divided by the aforementioned pixel defining film PDL (refer to FIG. 6B). The non-pixel region NPXA may be a region between neighboring pixel regions PXA-B, PXA-R, and PXA-G, and correspond to the pixel defining film PDL (refer to FIG. 6B). In this specification, each of the pixel regions PXA-B, PXA-R, and PXA-G may correspond to a "pixel". The pixel regions PXA-B, PXA-R, and PXA-G may be divided to correspond to the pixel opening OP (refer to FIG. 6B) defined in the pixel defining film PDL (refer to FIG. 6B).

As illustrated in FIG. 7A, the first pixel region PXA-B may constitute a first pixel group arranged along the second direction DR2, and the second pixel region PXA-R and the third pixel region PXA-G may constitute a second pixel group which are alternately arranged along the second direction DR2. Each of the first pixel group including the first pixel region PXA-B and the second pixel group including the second pixel region PXA-R and the third pixel region PXA-G may be spaced apart from each other along the first direction DR1. Each of the first pixel group and the second pixel group may be alternately arranged along the first direction DR1.

The pixel regions PXA-B, PXA-R, and PXA-G may have different areas according to the wavelength of emitted light. For example, as illustrated in FIG. 7A, the first pixel region PXA-B that emits the first light may have the largest area, and the second pixel region PXA-R that emits the second light may have the smallest area. However, the embodiment of the disclosure is not limited thereto, and the pixel regions PXA-B, PXA-R, and PXA-G may have the same area or be defined to have an area ratio different from that of FIG. 7A. The pixel regions PXA-B, PXA-R, and PXA-G may emit light of a color other than blue wavelength light, red wavelength light, and green wavelength light which are described above.

Each of the pixel regions PXA-B, PXA-R, and PXA-G may have a rectangular shape with rounded corners in a plan view. In an embodiment of the disclosure, each of the first pixel region PXA-B and the third pixel region PXA-G may have a rectangular shape with rounded corners, which has a long side extending in the second direction DR2 and a short side extending in the first direction DR1. In an embodiment of the disclosure, the second pixel region PXA-R may have a rectangular shape with rounded corners, which has a long side extending in the first direction DR1 and a short side extending in the second direction DR2.

In the display panel DP according to an embodiment of the disclosure, valley patterns VP1, VP2, and VP3 overlapping the non-pixel region NPXA and surrounding a portion of each of the pixel regions PXA-B, PXA-R, and PXA-G may be defined adjacent to each of the pixel regions PXA-B, PXA-R, and PXA-G. Each of the valley patterns VP1, VP2, and VP3 surround a portion of each of the pixel regions PXA-B, PXA-R, and PXA-G, but do not surround the remaining portion thereof. In this specification, the portion of the valley patterns VP1, VP2, and VP3, which does not surround the pixel regions PXA-B, PXA-R, and PXA-G, may be defined as an "opening portion". The ratio of the length of the opening portions to the length of the perimeter of each of the pixel regions PXA-B, PXA-R and PXA-G may be about 10% to about 50%. In case that the ratio is less than 10%, a driving voltage may excessively increase so that the efficiency of the display device may decrease. In case that the ratio is greater than 50%, an excessive lateral current leakage may cause color mixing between adjacent pixels, and accordingly, the optical characteristics of the display device may be deteriorated. The ratio may be referred to as an "opening proportion of the second electrode CE". For example, an opening proportion of 20% indicates that 20% of the perimeter is the opening portion and the remaining 80% is valley pattern/second electrode.

Table 1 below shows gray crushing measurement values according to the opening proportions of the above-described second electrode. Table 2 below shows driving voltage sag values and second electrode resistance values according to the opening proportions of the above-described second electrode. In case that the opening proportion of the second electrode is 100% in Table 1, this means that the valley pattern according to an embodiment of the disclosure is not defined. In Table 2, the "Comparative Example (20)" does not include a valley pattern recessed along the thickness direction as in this disclosure, but include a spacer pattern having a protrusion shape, which is formed on the pixel defining film, and the proportion of a portion in which the spacer pattern is not disposed in the perimeter of the pixel region is about 20%.

**[Table 1]**

| Second electrode opening proportion (%) | Gray crushing (%) |
|---|---|
| 20 | 91.4 |
| 30 | 88.7 |
| 40 | 88.7 |
| 100 | 64.2 |

**[Table 2]**

| Second electrode opening proportion (%) | Driving voltage sag (V) | Second electrode resistance (Ω) |
|---|---|---|
| 20 | -1.36 | 27.5 |
| 35 | -1.37 | 26 |
| 100 | -1.23 | 20 |
| Comparative example (20) | -1.69 | 29 |

Looking at the results of Tables 1 and 2, in the display panel according to an embodiment of the disclosure, as the ratio of the opening portion to the total perimeter is limited to about 10% to about 50%, the gray crushing proportion is maintained as high as about 85% or more. It may be seen that the resistance of the second electrode is not excessively increased, or the driving voltage is not significantly sagged. Through this, it may be seen that excellent optical characteristics may be secured without an excessive increase in a required driving voltage. In case that the spacer pattern having a protrusion shape is formed, it may be seen that the driving voltage is greatly sagged and the resistance of the second electrode is greatly increased, compared to the case of having a valley pattern of a shape recessed in the thickness direction as in the display panel according to an embodiment of the disclosure.

The valley patterns VP1, VP2, and VP3 may be defined in the aforementioned pixel defining film PDL (refer to FIG. 6B). In a cross-sectional view, the valley patterns VP1, VP2, and VP3 may have a shape recessed along the thickness direction of the pixel defining film PDL (refer to FIG. 6B) on the upper surface of the pixel defining film PDL (refer to FIG. 6B). A detailed description of the cross-sectional shapes of the valley patterns VP1, VP2, and VP3 will be described later.

The valley patterns VP1, VP2, and VP3 may include a first valley pattern VP1 surrounding a portion of the first pixel region PXA-B, a second valley pattern VP2 surrounding a portion of the second pixel region PXA-R, and a third valley pattern VP3 surrounding a portion of the third pixel region PXA-G. Each of the first valley pattern VP1, the second valley pattern VP2, and the third valley pattern VP3 may surround a portion of each of the first pixel region PXA-B, the second pixel region PXA-R, and the third pixel region PXA-G and may not surround the remaining portion thereof.

A first opening portion OPP1 that does not surround a portion of the first pixel region PXA-B may be defined in the first valley pattern VP1, a second opening portion OPP2 that does not surround a portion of the second pixel region PXA-R may be defined in the second valley pattern VP2, and a third opening portion OPP3 that does not surround a portion of the third pixel region PXA-G may be defined in the third valley pattern VP3.

In the first valley pattern VP1, the second valley pattern VP2, and the third valley pattern VP3 respectively defined in the first pixel region PXA-B, the second pixel region PXA-R, and the third pixel region PXA-G which are disposed adjacent to each other, the first opening portion OPP1, the second opening portion OPP2, and the third opening portion OPP3 respectively defined in the first valley pattern VP1, the second valley pattern VP2, and the third valley pattern VP3 may be defined so as not to face each other on a plane. In this specification, the expression "the opening portions are defined so as not to face each other on a plane" means that the opening portions of the valley regions defined in each pixel region do not overlap each other in the first or the second direction in a portion in which the shortest distance between the valley regions is defined, as illustrated in FIG. 7A, etc. In other words, the openings are not aligned with one another. For example, the first opening portion OPP1 may be defined in the first valley pattern VP1 defined around the first pixel region PXA-B, and an opening portion may not be defined in each of a portion of the second valley pattern VP2 and a portion of the third valley pattern VP3 closest to a portion in which the first opening portion OPP1 is defined. Similarly, an opening portion may not be defined in each of a portion of the first valley pattern VP1 and a portion of the third valley pattern VP3 closest to a portion in which the second opening portion OPP2 is defined, and an opening portion may not be defined in each of a portion of the first valley pattern VP1 and a portion of the second valley pattern VP2 closest to a portion in which the third opening portion OPP3 is defined.

Each of the first opening portion OPP1, the second opening portion OPP2, and the third opening portion OPP3 may be defined on a side of each of the first pixel region PXA-B, the second pixel region PXA-R, and the third pixel region PXA-G. For example, as illustrated in FIG. 7A, the first opening portion OPP1 may be defined to be adjacent to a long side extending in the second direction DR2 of the first pixel region PXA-B, the second opening portion OPP2 may be defined to be adjacent to a long side extending in the first direction DR1 of the second pixel region PXA-R, and the third opening portion OPP3 may be defined to be adjacent to a long side extending in the second direction DR2 of the third pixel region PXA-G. As illustrated in FIG. 7A, the first opening portion OPP1 may be defined to be adjacent to an end of a long side in the first direction DR1 of the first pixel region PXA-B, the second opening portion OPP2 may be defined to be adjacent to an end of a long side in the second direction DR2 of the second pixel region PXA-R, and the third opening portion OPP3 may be defined to be adjacent to an end of a long side in the first direction DR1 of the third pixel region PXA-G.

In an embodiment of the disclosure, in the first pixel region PXA-B, in case that a long side extending in the second direction DR2 is defined as a first lateral side and a short side extending in the first direction DR1 is defined as a second lateral side, the first opening portion OPP1 may be defined in the first lateral side. In the second pixel region PXA-R, in case that a short side extending in the second direction DR2 is defined as a third lateral side and a long side extending in the first direction DR1 is defined as a fourth lateral side, the second opening portion OPP2 may be defined in the fourth lateral side. For example, in the first pixel region PXA-B and the second pixel region PXA-R disposed adjacent to each other, the first opening portion OPP1 and the second opening portion OPP2 defined in the first valley pattern VP1 and the second valley pattern VP2 disposed adjacent to each of the first pixel region PXA-B and the second pixel region PXA-R may be defined to extend in different directions, respectively.

In the display device according to an embodiment of the disclosure, in order to prevent a lateral current leakage from occurring between adjacent pixels, the valley patterns VP1, VP2, and VP3 partially surrounding each pixel region may be defined. In this specification, the "lateral current leakage" means a current flowing in a direction intersecting the third direction DR3, which is the stacking direction of the light-emitting element, for example, the direction in which an image is displayed. The lateral current leakage may mean a current flowing in a direction parallel to a plane defined by the first direction DR1 and the second direction DR2. Since the valley patterns VP1, VP2, and VP3 recessed in the thickness direction of the pixel defining film are defined in the display device according to an embodiment of the disclosure, the lateral current leakage may be prevented from occurring, thereby preventing luminance decrease as well as color mixing between adjacent pixel regions.

In the display device according to an embodiment of the disclosure, the opening portions OPP1, OPP2, and OPP3 may be respectively formed in the valley patterns VP1, VP2, and VP3 to prevent excessive increase in a driving voltage. In the display device according to an embodiment of the disclosure, in the valley patterns VP1, VP2, and VP3 respectively defined adjacent pixel regions, the opening portions OPP1, OPP2, and OPP3 may be defined so as not to face each other. In case that the opening portions OPP1, OPP2, and OPP3 are defined to face each other, the lateral current leakage may occur between adjacent pixels in which the opening portions OPP1, OPP2, and OPP3 facing each other are defined. By defining the opening portions OPP1, OPP2, and OPP3 so as not to face each other in the display device according to an embodiment of the disclosure, it is possible to prevent a current from flowing in the direction of the plane, which is defined by the first direction DR1 and the second direction DR2. Accordingly, since an increase in the driving voltage of the display device is prevented while preventing color mixing between adjacent pixels and luminance decrease, the display efficiency of the display device may be improved.

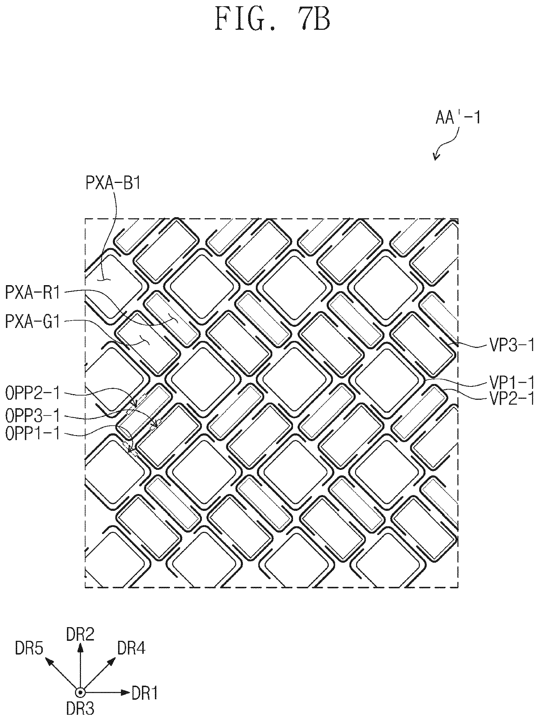

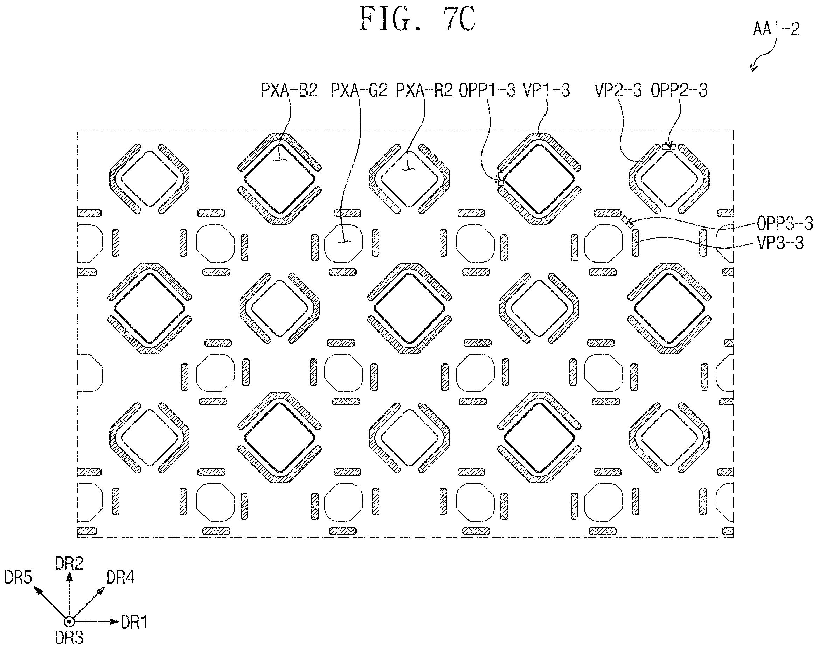

Each of FIGS. 7B and 7C illustrates an arrangement of pixels and the shapes of valley patterns defined to be adjacent thereto different from the embodiment illustrated in FIG. 7A. Hereinafter, the arrangement of pixels and the shapes of valley patterns different from the embodiment illustrated in FIG. 7A will be described with reference to FIGS. 7B and 7C.

Referring to FIG. 7B, the pixel regions PXA-B1, PXA-R1, and PXA-G1 may include a first pixel region PXA-B1, a second pixel region PXA-R1, and a third pixel region PXA-G1, and each of the first pixel region PXA-B1, the second pixel region PXA-R1, and the third pixel region PXA-G1 may display light having a different wavelength.

As illustrated in FIG. 7B, the first pixel regions PXA-B1 may have an arrangement in which they are spaced apart from each other along a fourth direction DR4 between the first direction DR1 and the second direction DR2 and along a fifth direction

DR5 intersecting the fourth direction DR4. The second pixel region PXA-R1 and the third pixel region PXA-G1 may be disposed between the first pixel regions PXA-B1 spaced apart from each other. In a plan view, the first pixel region PXA-B1 which emits a first light may have the largest area, and the second pixel region PXA-R1 which emits a second light may have the smallest area.

Each of the pixel regions PXA-B1, PXA-R1, and PXA-G1 may have a rectangular shape with rounded corners in a plan view. In an embodiment of the disclosure, the first pixel region PXA-B1 may have a square shape with rounded corners and sides having the same length and extending in each of the fourth and fifth directions DR4 and DR5. Each of the second pixel region PXA-R1 and the third pixel region PXA-G1 may have a rectangular shape with rounded corners, which has a long side extending in one of the fourth and fifth directions DR4 and DR5 and a short side extending in the other direction thereof.

In a first valley pattern VP1-1, a second valley pattern VP2-1, and a third valley pattern VP3-1 respectively defined in the first pixel region PXA-B1, the second pixel region PXA-R1, and the third pixel region PXA-G1 which are disposed adjacent to each other, a first opening portion OPP1-1, a second opening portion OPP2-1, and a third opening portion OPP3-1 respectively defined in the first valley pattern VP1-1, the second valley pattern VP2-1, and the third valley pattern VP3-1 may be defined so as not to face each other on a plane. The first opening portion OPP1-1 may be defined in the first valley pattern VP1-1 defined around the first pixel region PXA-B1, and an opening portion may not be defined in each of a portion of the second valley pattern VP2-1 and a portion of the third valley pattern VP3-1 closest to a portion in which the first opening portion OPP1-1 is defined. Similarly, an opening portion may not be defined in each of a portion of the first valley pattern VP1-1 and a portion of the third valley pattern VP3-1 closest to a portion in which the second opening portion OPP2-1 is defined, and an opening portion may not be defined in each of a portion of the first valley pattern VP1-1 and a portion of the second valley pattern VP2-1 closest to a portion in which the third opening portion OPP3-1 is defined.

Referring to FIG. 7C, the pixel regions PXA-B2, PXA-R2, and PXA-G2 may include a first pixel region PXA-B2, a second pixel region PXA-R2, and a third pixel region PXA-G2, and each of the first pixel region PXA-B2, the second pixel region PXA-R2, and the third pixel region PXA-G2 may display light having a different wavelength.

As illustrated in FIG. 7C, the first pixel regions PXA-B2 and the second pixel regions PXA-R2 may constitute a first pixel group, which are alternately arranged along the first direction DR1, and the third pixel regions PXA-G2 may constitute a second pixel group, which are arranged along the first direction DR1. Each of the first pixel group composed of the first pixel regions PXA-B2 and the second pixel regions PXA-R2 and the second pixel group composed of the third pixel regions PXA-G2 may be spaced apart from each other along the second direction DR2. Each of the first pixel group and the second pixel group may be alternately arranged along the second direction DR2. In a plan view, the first pixel region PXA-B2 which emits a first light may have the largest area, and the third pixel region PXA-G2 which emits a third light may have the smallest area. Within a unit area, the third pixel region PXA-G2 may be disposed twice as many as each of the first pixel region PXA-B2 and the second pixel region PXA-R2.

Each of the pixel regions PXA-B2, PXA-R2, and PXA-G2 may have a polygonal shape with rounded corners in a plan view. In an embodiment of the disclosure, each of the first pixel region PXA-B2 and the second pixel region PXA-R2 may have a square shape with rounded corners and sides having the same length and extending in each of fourth and fifth directions DR4 and DR5. The third pixel region PXA-G2 may have sides extending in any one of the fourth direction DR4 and the fifth direction DR5, and the remaining portion thereof may have rounded shapes.

In a first valley pattern VP1-3, a second valley pattern VP2-3, and a third valley pattern VP3-3 respectively defined in the first pixel region PXA-B2, the second pixel region PXA-R2, and the third pixel region PXA-G2 which are disposed adjacent to each other, a first opening portion OPP1-3, a second opening portion OPP2-3, and a third opening portion OPP3-3 respectively defined in the first valley pattern VP1-3, the second valley pattern VP2-3, and the third valley pattern VP3-3 may be defined so as not to face each other on a plane. The first opening portion OPP1-3 may be defined in the first valley pattern VP1-3 defined around the first pixel region PXA-B2, and an opening portion may not be defined in each of a portion of the second valley pattern VP2-3 and a portion of the third valley pattern VP3-3 closest to a portion in which the first opening portion OPP1-3 is defined. Similarly, an opening portion may not be defined in each of a portion of the first valley pattern VP1-3 and a portion of the third valley pattern VP3-3 closest to a portion in which the second opening portion OPP2-3 is defined, and an opening portion may not be defined in each of a portion of the first valley pattern VP1-3 and a portion of the second valley pattern VP2-3 closest to a portion in which the third opening portion OPP3-3 is defined.

As illustrated in FIG. 7C, in an embodiment of the disclosure, in case that a side extending in the fourth direction DR4 of the first pixel region PXA-B2 is defined as a first lateral side and a side extending in the fifth direction DR5 is defined as a second lateral side, the first opening portion OPP1-3 may be defined at vertexes spaced apart from each other along the first direction DR1 among points at which the first lateral side and the second lateral side meet each other, and in case that a side extending in the fourth direction DR4 of the second pixel region PXA-R2 is defined as a third lateral side and a side extending in the fifth direction DR5 is defined as a fourth lateral side, the second opening portion OPP2-3 may be defined at vertexes spaced apart from each other along the second direction DR2 among points at which the third lateral side and the fourth lateral side meet each other. Accordingly, in the first pixel region PXA-B2 and the second pixel region PXA-R2 disposed adjacent to each other, the first opening portion OPP1-3 and the second opening portion OPP2-3 respectively defined in the first and second valley patterns VP1-3 and VP2-3 respectively disposed adjacent to the first pixel region PXA-B2 and the second pixel region PXA-R2 may be defined so as not to face each other.

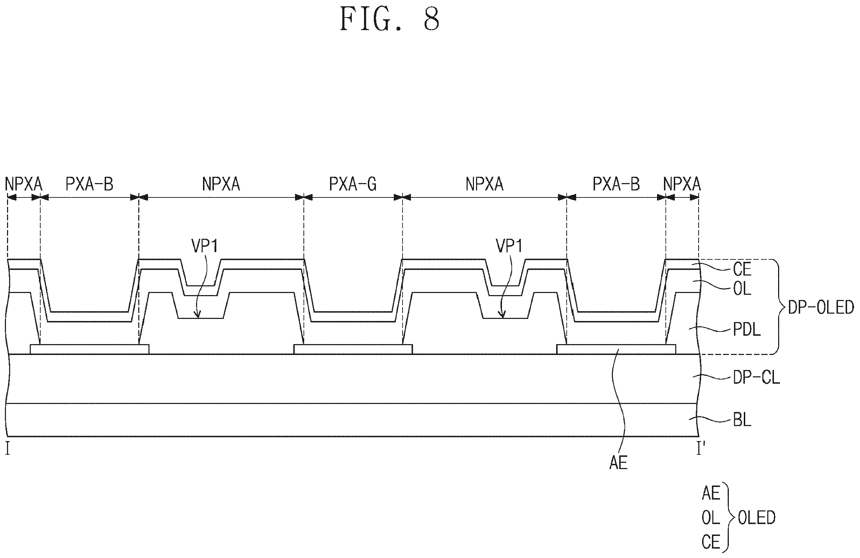

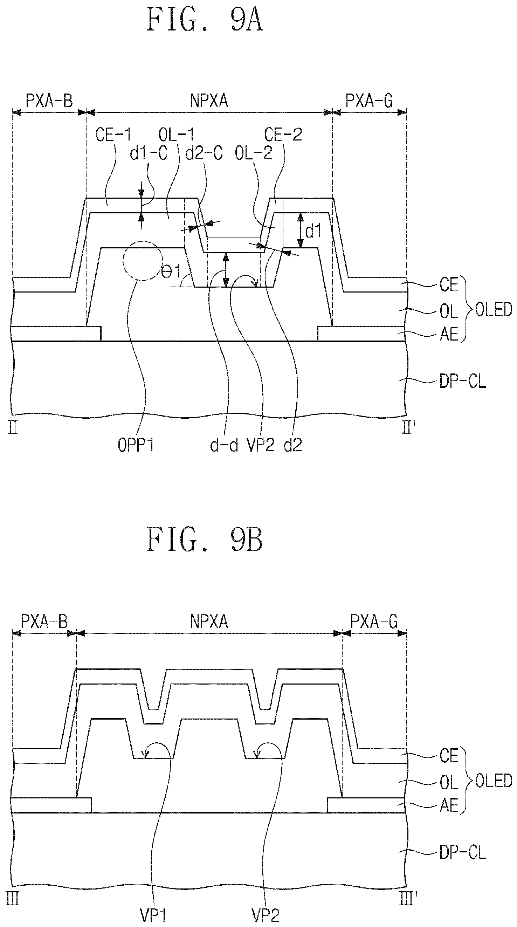

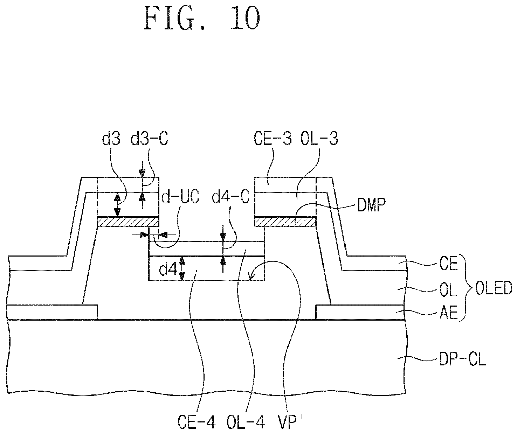

FIG. 8 is a schematic cross-sectional view of the display panel according to an embodiment of the disclosure. FIGS. 9A and 9B are enlarged schematic cross-sectional views of portions of the display panel according to an embodiment of the disclosure. FIG. 10 is an enlarged schematic cross-sectional view of a portion of a display panel according to another embodiment of the disclosure. FIG. 8 illustrates a cross section taken along line I-I' illustrated in FIG. 7A. FIG. 9A illustrates a cross section taken along line II-II' illustrated in FIG. 7A. FIG. 9B illustrates a cross section taken along line III-III' illustrated in FIG. 7A. FIG. 10 illustrates a cross section according to another embodiment of the disclosure based on the cross section illustrated in FIG. 9A.

Referring to FIGS. 7A, 8, 9A, and 9B together, the display panel according to an embodiment of the disclosure includes a base layer BL, a circuit element layer DP-CL disposed on the base layer BL, and a display element layer DP-OLED. Although not illustrated in FIGS. 8, 9A, 9B, etc., an upper insulating layer TFL (refer to FIG. 2A) may be further disposed on the display element layer DP-OLED.

The light-emitting element OLED disposed on the circuit element layer DP-CL may include a first electrode AE, an organic layer OL, and a second electrode CE which are sequentially stacked. The organic layer OL may include at least a light-emitting layer EML (refer to FIG. 6B). The organic layer OL may include, for example, a hole control layer HCL, a light-emitting layer EML, and an electron control layer ECL which are sequentially stacked as described above with reference to FIG. 6B. In another example, the organic layer OL may include multiple light-emitting stacks ST1, ST2, and ST3 and charge generation layers CGL1 and CGL2 disposed between the light-emitting stacks ST1, ST2, and ST3, which are sequentially stacked as described above with reference to FIG. 6C.

Valley patterns VP1, VP2, and VP3 overlapping the non-pixel region NPXA may be defined in the pixel defining film PDL disposed on the circuit element layer DP-CL. As illustrated in FIGS. 8, 9A, 9B, etc., the valley patterns VP1, VP2, and VP3 may have a shape recessed from the upper surface of the pixel defining film PDL in the third direction DR3, which is the thickness direction. In the following description, the second valley pattern VP2 is referred to as a "valley pattern" and the depth and taper angle thereof are described, but the same description may be applied to the first valley pattern VP1 and the third valley pattern VP3.

Referring to FIG. 9A, the recess depth d-d of the recessed valley pattern VP2 may be about 100 nm to about 500 nm. In case that the recess depth d-d is less than about 100 nm, the degree of reducing the thickness of the organic layer OL and the second electrode CE disposed on the pixel defining film PDL is so small that the effect of preventing a lateral current leakage may be reduced. In case that the recess depth d-d is greater than about 500 nm, the organic layer OL and the second electrode CE disposed on the pixel defining film PDL may be damaged.

The valley pattern VP2 having a recessed shape may include a lower surface and a side surface, and the side surface may be inclined at a predetermined (or selectable) angle with respect to the lower surface. In an embodiment of the disclosure, the taper angle θ1 at which the side surface is inclined from the lower surface may be about 70 degrees to about 90 degrees. In case that the taper angle θ1 is less than 70 degrees, the degree of reducing the thickness of the organic layer OL and the second electrode CE disposed on the pixel defining film PDL is so small that the effect of preventing a lateral current leakage may be reduced. In case that the taper angle θ1 is greater than 90 degrees, the side surface of the valley pattern VP2 may have a reverse taper structure, and therefore damage such as cracks may occur in the upper insulating layer TFL (refer to FIG. 6A) disposed thereon.

Portions of the organic layer OL and the second electrode CE may be disposed inside the valley pattern VP2.

In an embodiment of the disclosure, the organic layer OL may include a first portion OL-1 disposed on the upper surface of the pixel defining film PDL and a second portion OL-2 disposed on the side surface of the valley pattern VP2. The second electrode CE may include a first electrode portion CE-1 disposed on the first portion OL-1 and a second electrode portion CE-2 disposed on the second portion OL-2.

In an embodiment of the disclosure, the thickness d2 of the second portion OL-2 may be smaller than the thickness d1 of the first portion OL-1. The thickness d2 of the second portion OL-2 may be about 10% to about 20% of the thickness d1 of the first portion OL-1. In an embodiment of the disclosure, the thickness d1 of the first portion OL-1 may be about 200 nm to about 300 nm, and the thickness d2 of the second part OL-2 may be about 30 nm to about 55 nm.

In an embodiment of the disclosure, the thickness d2-C of the second electrode portion CE-2 may be smaller than the thickness d1-C of the first electrode portion CE-1. The thickness d2-C of the second electrode portion CE-2 may be about 10% to about 20% of the thickness d1-C of the first electrode portion CE-1. In an embodiment of the disclosure, the thickness d1-C of the first electrode portion CE-1 may be about 90 Å to about 120 Å, and the thickness d2-C of the second electrode portion CE-2 may be about 10 Å to about 35 Å.

Since the valley pattern VP2 having a shape recessed in the thickness direction of the pixel defining film PDL is formed in the display device according to an embodiment of the disclosure, the thicknesses of the second portion OL-2 of the organic layer OL and the second electrode portion CE-2 of the second electrode CE, which are disposed on the side surface of the valley pattern VP2-2, may be formed to be small. As the thickness of each of the second portion OL-2 and the second electrode portion CE-2 decreases, the resistance of the second portion OL-2 and the second electrode portion CE-2 increases. Accordingly, it is possible to prevent a current from leaking to a portion in which the valley pattern VP2 with increased resistance is formed.

Referring to FIGS. 7A and 9A together, the portion in which the opening portion OPP1 is formed may be a portion in which the upper surface of the pixel defining film PDL is not recessed and maintains a flat upper surface. Accordingly, in the portion in which the opening portion OPP1 is formed, the effect of reducing the thicknesses of the organic layer OL and the second electrode CE due to a valley pattern may not be achieved.

As described above, since the display panel according to an embodiment of the disclosure has the opening portions OPP1, OPP2, and OPP3 formed so as not to face each other, the display panel does not include a structure in which the opening portions OPP1, OPP2, and OPP3 are formed side by side on a cross section between adjacent pixels, but has a cross-sectional structure in which two valley patterns VP1 and VP2 are formed side by side on a cross section between adjacent pixels as illustrated in FIG. 9B, or a structure in which one valley pattern VP2 is defined in a cross section on which one opening portion OPP1 is defined as illustrated in FIG. 9A. Accordingly, it is possible to effectively prevent a current from flowing in the direction of a plane defined by the first direction DR1 and the second direction DR2 between adjacent pixels.

Referring to FIGS. 8 and 10, the display panel according to an embodiment of the disclosure may further include a dummy portion DMP disposed on the pixel defining film PDL and partially overlapping a valley pattern VP'. The dummy portion DMP may be disposed on the upper surface of the pixel defining film PDL, and the organic layer OL and the second electrode CE may be disposed on the dummy portion DMP.

In an embodiment of the disclosure, the dummy portion DMP may be a remaining portion of a mask used in a process of forming the valley pattern VP'. In the display panel according to an embodiment of the disclosure, an inorganic oxide film may be patterned to be used as a mask in order to form the valley pattern VP', and the dummy portion DMP may be a remaining portion without being etched as a portion of the inorganic oxide film mask to form the valley pattern VP'. In an embodiment of the disclosure, the dummy portion DMP may include indium gallium zinc oxide (IGZO).

The dummy portion DMP may include a portion protruding from the side surface of the valley pattern VP' by a predetermined (or selectable) length. The protrusion length d-UC of the dummy portion DMP protruding from the side surface of the valley pattern VP' may be, for example, about 0.05 micrometers to about 0.1 micrometers.

In an embodiment of the disclosure, in case that a portion of the organic layer OL disposed on the dummy portion DMP is referred to as a third portion OL-3, and a portion of the organic layer OL disposed in the valley pattern VP' is referred to as a fourth portion OL-4, the third portion OL-3 and the fourth portion OL-4 may be separated from each other without being connected to each other. In case that a portion of the second electrode CE disposed on the third portion OL-3 is referred to as a third electrode portion CE-3, and a portion disposed on the fourth portion OL-4 is referred to as a fourth electrode portion CE-4, the third electrode portion CE-3 and the fourth electrode portion CE-4 may be separated from each other without being connected to each other. The thickness d3 of the third portion OL-3 and the thickness d4 of the fourth portion OL-4 may be substantially the same as each other. The thickness d3-C of the third electrode portion CE-3 and the thickness d4-C of the fourth electrode portion CE-4 may be substantially the same as each other.

Since the display panel according to an embodiment of the disclosure includes the dummy portion DMP protruding from the side surface of the valley pattern VP' by a predetermined (or selectable) length, the organic layer OL and the second electrode CE included in the display panel may have a shape in which they are separated by the valley pattern VP'. Accordingly, it is possible to prevent a current from flowing in the direction of a plane defined by the first direction DR1 and the second direction DR2 between adjacent pixels.

FIG. 11 is a graph showing the display quality result of the display panel according to embodiments of the inventive concept and a reference example. FIG. 11 shows the measured gray crushing value of each of a first pixel region configured to display blue light, a second pixel region configured to display red light, and a third pixel region configured to display green light in the display panel according to the embodiments and the reference example. In FIG. 11, the measured value of the first pixel region is indicated as "B", the measured value of the second pixel region is indicated as "R", and the measured value of the third pixel region is indicated as "G", and the measured values were measured 10 times in each pixel region. In case that, the display panel of Embodiment 1 corresponds to the display panel having the pixel arrangement structure and the first to third valley patterns described above in FIG. 7C, wherein the side taper angle of the valley pattern is formed to be about 70 degrees to about 90 degrees. The display panel of Embodiment 2 corresponds to the display panel having the same pixel arrangement structure and first to third valley patterns as described in Embodiment 1, wherein the side taper angle of the valley pattern is formed to be about 20 degrees to about 30 degrees. The display panel of Reference Example corresponds to the display panel which has the same pixel arrangement structure as described in Embodiment 1, but in which the first to third valley patterns are not formed.

Referring to FIG. 11, as the display panel according to an embodiment of the inventive concept includes valley patterns formed adjacent to pixel regions, it can be seen that all gray crushing values are improved in all of the first to third pixel regions. Meanwhile, the average of the gray crushing values measured in the pixel regions of each of Reference Example, Embodiment 1, and Embodiment 2 is calculated as shown in Table 3 below.

**[Table 3]**

| Division | First pixel region (B) | Second pixel region (R) | Third pixel region (G) |
|---|---|---|---|
| Reference Example | 93.7% | 64.6% | 53.4% |
| Embodiment 2 | 96.1% | 77.0% | 69.4% |
| Embodiment 1 | 99.6% | 92.3% | 96.8% |

Referring to FIG. 11 and Table 3 together, as the display panel according to an embodiment of the inventive concept includes valley patterns formed adjacent to pixel regions, it can be seen that all gray crushing values are improved in all of the first to third pixel regions. In particular, when the side taper angle of the valley pattern is formed to be as large as about 70 degrees to about 90 degrees as in Embodiment 1, it can be seen that the second pixel region and the third pixel region have high gray crushing values, compared to when the side taper angle of the valley pattern is formed to be as small as about 20 degrees to about 30 degrees as in Embodiment 2. As the display panel of Embodiment 1 includes the valley pattern having a side taper angle of about 70 degrees to about 90 degrees, it can be seen that the gray crushing values are maintained as high as about 90% or more in all of the first to third pixel regions. Through this, it can be seen that the display panel according to the embodiment of the inventive concept may have excellent optical characteristics as the display panel includes valley patterns formed adjacent to pixel regions, and in particular, when the taper angle of the valley patterns is formed to be as large as about 70 degrees to about 90 degrees, the effect of improving the optical characteristics is further increased.

According to the display device and the electronic device including the same in accordance with an embodiment of the disclosure, an opening portion may be formed in a valley pattern by a predetermined (or selectable) ratio, while a lateral current leakage may be prevented by the valley pattern defined between adjacent pixels. In the display device and the electronic device according to an embodiment of the disclosure, the opening portion may be formed to prevent an excessive increase in a driving voltage, and adjacent opening portions may be formed so as not to face each other, thereby effectively block a lateral current leakage.

The above description is an example of technical features of the disclosure, and those skilled in the art to which the disclosure pertains will be able to make various modifications and variations. Therefore, the embodiments of the disclosure described above may be implemented separately or in combination with each other.

Therefore, the embodiments disclosed in the disclosure are not intended to limit the disclosure. The invention is defined by the claims.

## Claims

1. A display device comprising:
a base layer (BL) on which a plurality of pixel regions (PXA) and a non-pixel region (NPXA) are defined, the pixel regions comprising a first pixel region (PXA-B) and a second pixel region (PXA-R) adjacent to the first pixel region, and the non-pixel region being disposed adjacent to the plurality of pixel regions;
a pixel defining film (PDL) disposed on the base layer and comprising a pixel opening corresponding to each of the plurality of pixel regions; and
a light-emitting element layer at least partially disposed in the pixel opening, wherein
a valley pattern (VP1, VP2, VP3) around portions of each of the plurality of pixel regions is defined in the pixel defining film,
the valley pattern comprising:
a first valley pattern (VP1) around the first pixel region (PXA-B);
a second valley pattern (VP2) around the second pixel region (PXA-R),
a first opening portion (OPP1) in the first valley pattern (VP1); and
a second opening portion (OPP2) in the second valley pattern (VP2),
wherein
the first opening portion and the second opening portion do not face each other.

2. The display device of claim 1, wherein the valley pattern has a shape recessed from an upper surface of the pixel defining film in a thickness direction of the pixel defining film.

3. The display device of claim 2, wherein the depth of the valley pattern is in the range of about 100 nm to about 500 nm.

4. The display device of claim 2 or 3, wherein
the valley pattern comprises:
a lower surface parallel to the upper surface of the pixel defining film; and
a side surface connecting the lower surface of the valley pattern and the upper surface of the pixel defining film to each other and inclined from the lower surface of the valley pattern, and
an angle of the side surface is in the range of about 70 degrees to about 90 degrees.

5. The display device of claim 4, wherein
the light-emitting element layer comprises:
a first electrode disposed on the base layer;
an organic layer disposed on the first electrode and the pixel defining film and including a light-emitting layer; and
a second electrode disposed on the organic layer, and
a portion of the organic layer and a portion of the second electrode are disposed in the valley pattern.

6. The display device of claim 5, wherein
the organic layer comprises:
a first portion disposed on the upper surface of the pixel defining film; and
a second portion disposed on the side surface, and
a thickness of the second portion is less than a thickness of the first portion in the thickness direction.

7. The display device of claim 6, wherein the thickness of the second portion is in the range of about 10% to about 20% of the thickness of the first portion.

8. The display device of any one of claims 5 to 7, wherein
the second electrode comprises:
a first electrode portion disposed on the upper surface of the pixel defining film; and
a second electrode portion disposed on the side surface, and
a thickness of the second electrode portion is less than a thickness of the first electrode portion in the thickness direction.

9. The display device of any one of claims 5 to 8, further comprising:
a dummy portion disposed on the pixel defining film and partially overlapping the valley pattern in a plan view, wherein
the organic layer comprises:
a third portion disposed on the dummy portion; and
a fourth portion disposed on the lower surface of the valley pattern, and the third portion and the fourth portion are not connected to each other.

10. The display device of claim 9, wherein
the dummy portion comprises a protruding portion protruding from the side surface of the valley pattern, and
a length of the protruding portion is in the range of about 0.05 micrometers to about 0.1 micrometers in a cross-sectional view.

11. The display device of any one of claims 5 to 10, wherein the organic layer comprises:
a hole control layer disposed on the first electrode and the pixel defining film;
the light-emitting layer disposed on the hole control layer; and
an electron control layer disposed between the light-emitting layer and the second electrode, and optionally
wherein the organic layer comprises:
a first light-emitting stack disposed on the first electrode and the pixel defining film and comprising a first light-emitting layer;
a first charge generation layer disposed on the first light-emitting stack; and
a second light-emitting stack disposed between the first charge generation layer and the second electrode and comprising a second light-emitting layer.

12. The display device of any one of the preceding claims, wherein
at least a portion of the first pixel region and at least a portion of the second pixel region are disposed adjacent to each other in a first direction,
the first pixel region comprises:
a first lateral side extending in a second direction intersecting the first direction; and
a second lateral side extending from the first lateral side in the first direction,
the second pixel region comprises:
a third lateral side extending in the second direction and facing the first lateral side; and
a fourth lateral side extending from the third lateral side in the first direction,
the first opening portion is defined adjacent to the first lateral side, and
the second opening portion is defined adjacent to the fourth lateral side.

13. The display device of any one of claims 1 to 11, wherein
at least a portion of the first pixel region and at least a portion of the second pixel region are disposed adjacent to each other in a first direction,
the first pixel region comprises:
a first lateral side extending in a fourth direction that is a direction between the first direction and a second direction intersecting the first direction; and
a second lateral side extending from the first lateral side in a fifth direction intersecting the fourth direction,
the second pixel region comprises:
a third lateral side extending in the fourth direction; and
a fourth lateral side extending from the third lateral side in the fifth direction,
the first opening portion is defined adjacent to two vertices at which the first lateral side and the second lateral side meet each other and which are spaced apart from each other in the first direction, and
the second opening portion is defined adjacent to two vertices at which the third lateral side and the fourth lateral side meet each other and which are spaced apart from each other in the second direction.

14. The display device of any one of the preceding claims, wherein
the plurality of pixel regions further comprise a third pixel region (PXA-G) adjacent to the second pixel region (PXA-R),
the valley pattern further comprises a third valley pattern (VP3) surrounding a portion of the third pixel region,
the display device further comprising a third opening portion (OPP3) disposed at which the third valley pattern does not surround the third pixel region, and
the third opening portion does not face the second opening portion.

15. The display device of any one of the preceding claims, wherein
a ratio of the lengths of the first opening portion and the perimeter around the first pixel region is in the range of about 10% to about 50%, and
a ratio of the lengths of the second opening portion and the perimeter around the second pixel region is in the range of about 10% to about 50%.
